# EUROPEAN PATENT APPLICATION

(11) **EP 4 727 167 A1**
(43) Date of publication of application: **15.04.2026**
(21) Application number: 25207671.6
(22) Date of filing: 09.10.2025
(51) Int. Cl.: H04R 3/00, H04R 29/00, H04R 3/12

(54) **SYSTEM FOR DEBUGGING AUDIO AMPLIFIER OF A VEHICLE**

(30) Priority: 11.10.2024 US 202418912759
(71) Applicant: Harman Becker Automotive Systems, Inc., Novi, MI 48377 (US)
(72) Inventor: LIU, Chong, Ann Arbor, MI, 48105 (US); RASMUSSEN, Claus Mygind, 7400 Herning (DK); SONG, Junqian, Northville, MI, 48167 (US)
(74) Representative: Rummler, Felix

(57) **Abstract**

An audio system in a vehicle includes at least one controller including one or more processors being programmed to provide an output audio signal; a first integrated circuit (IC) configured to drive a first loudspeaker; and a first switch including: a first terminal being operably coupled to a first feedback wire from the first loudspeaker, a second terminal being operably coupled to a component of the first IC, and a third terminal being operably coupled with the one or more processors, wherein the first switch is configured to selectively connect the first terminal to one of the second terminal or the third terminal.

## Description

### TECHNICAL FIELD

The present disclosure relates to a vehicle system that enables debugging access to an audio controller/amplifier.

### BACKGROUND

Modem vehicles are provided with one or more audio systems configured to provide audio sounds to vehicle users. The audio system may include an audio controller/amplifier driving a plurality of loudspeakers to provide multi-channel sounds. Conventionally, the audio controller/amplifier may be provided with one or more dedicated debugging ports to allow a technician to directly access the controller. While having a dedicated debugging port provides convenient access, it also has a few drawbacks. For instance, the dedicated port may increase the cost for the manufacturer. Additionally, the dedicated port rises cybersecurity concerns since it allows direct access to the audio controller.

### SUMMARY

In one or more exemplary embodiments of the present disclosure, an audio system in a vehicle includes at least one controller including one or more processors being programmed to provide an output audio signal; a first integrated circuit (IC) configured to drive a first loudspeaker; and a first switch including: a first terminal being operably coupled to a first feedback wire from the first loudspeaker, a second terminal being operably coupled to a component of the first IC, and a third terminal being operably coupled with the one or more processors, wherein the first switch is configured to selectively connect the first terminal to one of the second terminal or the third terminal.

In one or more exemplary embodiments of the present disclosure, an audio system includes at least one controller including one or more processors being programmed to provide an output audio signal; a first integrated circuit (IC) configured to drive a first loudspeaker; and a first switch including: a first terminal being operably coupled to the first loudspeaker, a second terminal being operably coupled to the first IC, and a third terminal being operably coupled with the one or more processors, wherein the first switch is configured to selectively connect the first terminal to one of the second terminal or the third terminal.

In one or more exemplary embodiments of the present disclosure, an audio system for an automobile, the audio system includes one or more processors being programmed to provide an output audio signal; a first integrated circuit (IC) configured to drive a first loudspeaker; and a first switch including: a first terminal being operably coupled to a first feedback wire from the first loudspeaker, a second terminal being operably coupled to a component of the first IC, and a third terminal being operably coupled with the one or more processors, wherein the first switch is configured to selectively connect the first terminal to one of the second terminal or the third terminal.

### BRIEF DESCRIPTION OF THE DRAWINGS

For a better understanding of the invention and to show how it may be performed, embodiments thereof will now be described, by way of non-limiting example only, with reference to the accompanying drawings, in which:
Figure 1 illustrates an example block topology of a vehicle system of one embodiment of the present disclosure.
Figure 2 illustrates an example block diagram of an audio system of one embodiment of the present disclosure.
Figure 3 illustrates an example block diagram of an audio system of another embodiment of the present disclosure.
Figure 4 illustrates an example flow diagram of a process for switching the audio controller between a normal operating mode and a debugging mode of one embodiment of the present disclosure.

### DETAILED DESCRIPTION

Embodiments are described herein. It is to be understood, however, that the disclosed embodiments are merely examples and other embodiments may take various and alternative forms. The figures are not necessarily to scale. Some features could be exaggerated or minimized to show details of particular components. Therefore, specific structural and functional details disclosed herein are not to be interpreted as limiting, but merely as a representative basis for teaching one skilled in the art.

Various features illustrated and described with reference to any one of the figures may be combined with features illustrated in one or more other figures to produce embodiments that are not explicitly illustrated or described. The combinations of features illustrated provide representative embodiments for typical applications. Various combinations and modifications of the features consistent with the teachings of this disclosure, however, could be desired for particular applications or implementations.

The present disclosure proposes, among other things, a vehicle system that enables debugging access to an audio controller/amplifier without providing a dedicated debugging port.

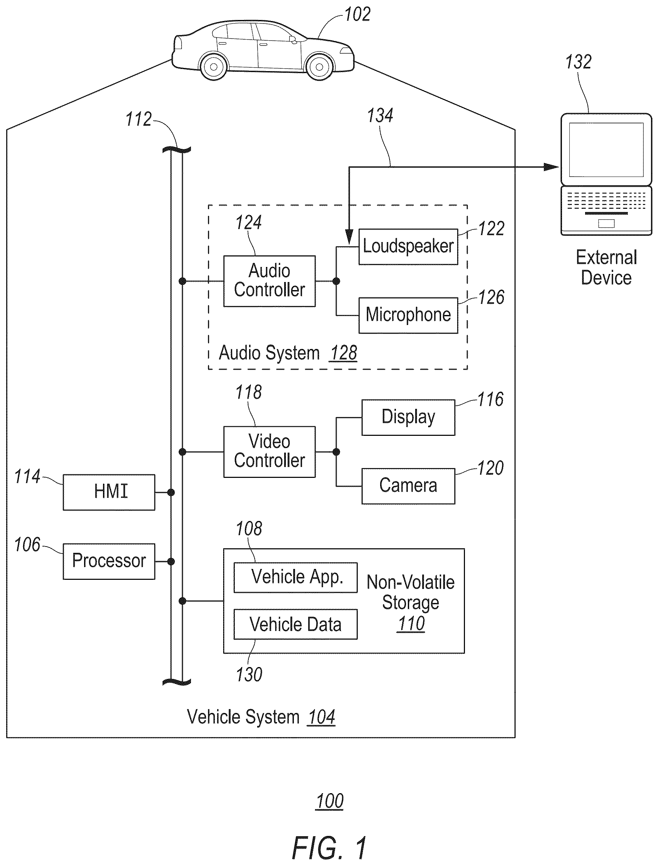

Referring to Figure 1, an example block topology of a system 100 of one embodiment of the present disclosure is illustrated. A vehicle 102 may include various types of automobiles, crossover utility vehicle (CUV), sport utility vehicle (SUV), truck, recreational vehicle (RV), boat, plane, or other mobile machine for transporting people or goods. In many cases, the vehicle 102 may be powered by an engine. As another possibility, the vehicle 102 may be a battery electric vehicle (BEV), a hybrid electric vehicle (HEV) powered by both an internal combustion engine and one or move electric motors, such as a series hybrid electric vehicle (SHEV), a plug-in hybrid electric vehicle (PHEV), a parallel/series hybrid vehicle (PSHEV), or a fuel-cell electric vehicle (FCEV). It should be noted that the illustrated system 100 is merely an example, and more, fewer, and/or differently located elements may be used.

As illustrated in Figure 1, the vehicle 102 may be provided with a vehicle system 104 including one or more processors 106 configured to perform instructions, commands, and other routines in support of the processes described herein. For instance, the vehicle system 104 may be configured to execute instructions of applications 108 to provide features such as vehicle operation controls, multimedia, or the like. Such instructions and other data may be maintained in a non-volatile manner using a variety of types of computer-readable storage medium 110. The computer-readable medium 110 (also referred to as a processor-readable medium or storage) includes any non-transitory medium that participates in providing instructions or other data that may be read by the processor 106 of the vehicle system 104. Computer-executable instructions may be compiled or interpreted from computer programs created using a variety of current and future programming languages and/or technologies.

The vehicle system 104 may be provided with one or more in-vehicle networks 112 configured to enable the communication between various components of the vehicle 102. The in-vehicle network 112 may be configured to support various communication protocol. For instance, the in-vehicle network 112 may be configured to support, but is not limited to, one or more of a controller area network (CAN), an Ethernet network, and a media-oriented system transport (MOST), as some examples. Furthermore, the in-vehicle network 112, or portions of the in-vehicle network 112, may be a wireless network accomplished via Bluetooth low-energy (BLE), Wi-Fi, ultra-wideband (UWB) or the like.

The vehicle system 104 may be provided with various features allowing the vehicle users to interface with the vehicle system 104. For example, the computing platform 104 may receive input from human machine interface (HMI) controls 114 connected to the in-vehicle network 112 and configured to provide for user interaction with the vehicle 102. As an example, the vehicle system 104 may interface with one or more buttons, switches, knobs, touch screen or other HMI controls configured to invoke functions on the vehicle system 104 (e.g., audio/video playback, and etc.).

The vehicle system 104 may also drive or otherwise communicate with one or more displays 116 configured to provide visual output to vehicle users by way of a video controller 118 through the in-vehicle network 112. In some cases, the display 116 may be a touch screen further configured to receive user touch input via the video controller 118, while in other cases the display 116 may be a display only, without touch input capabilities. The vehicle system 104 may also drive or otherwise communicate with one or more cameras 120 configured to provide video input by way of the video controller 118 through the in-vehicle network 112. The cameras 120 may include one or more in-cabin dash cameras configured to capture images inside and/or outside the cabin of the vehicle 102. Additionally or alternatively, the cameras 120 may include one or more exterior cameras (e.g., backup cameras) located outside the vehicle cabin.

The vehicle system 104 may also drive or otherwise communicate with one or more loudspeakers 122 configured to provide audio output to vehicle users by way of an audio controller 124 connected to the in-vehicle network 112. The vehicle system 104 may also drive or otherwise communicate with one or more microphones 126 configured to capture audio input by way of the audio controller 124. The audio controller 124 in combination with the loudspeakers 122 and the microphones 126 constitutes an audio system 128 of the vehicle 102.

The audio controller 124 may be also referred to as an audio amplifier configured to drive the loudspeakers 122 and microphones 126 by providing sufficient power thereto without distortion. The audio controller 124 may be further configured to process and output various audio medium data (e.g., digital music files) via the loudspeakers 122. The audio medium data may be stored in the storage 110 as a part of vehicle data 130.

As discussed above, the present disclosure proposes a system that enables debugging access to an audio controller 124 without providing a dedicated debugging port to the audio controller 124. More specifically, the present disclosure provide access to the audio controller 124 via one or more existing wires/cable connecting the audio controller 124 with the loudspeakers 122 and/or the microphones 126. In the present example illustrated in Figure 1, an external device 132 may access the audio controller 124 via wires connected between the audio controller 124 and the one or more microphones 122 through a debugging cable 134. For instance, the debugging cable 134 may include one or more metal probes configured to tap into wires via metal contacts (e.g., preferably exposed metal contacts). The external device 132 may be any of various types of portable computing devices, such as laptop computers, desktop computers, diagnostic devices, smart phones, tablet computers, or other device capable of communication with the audio system 128 through regular and dedicated debug port, which is a current and common approach.

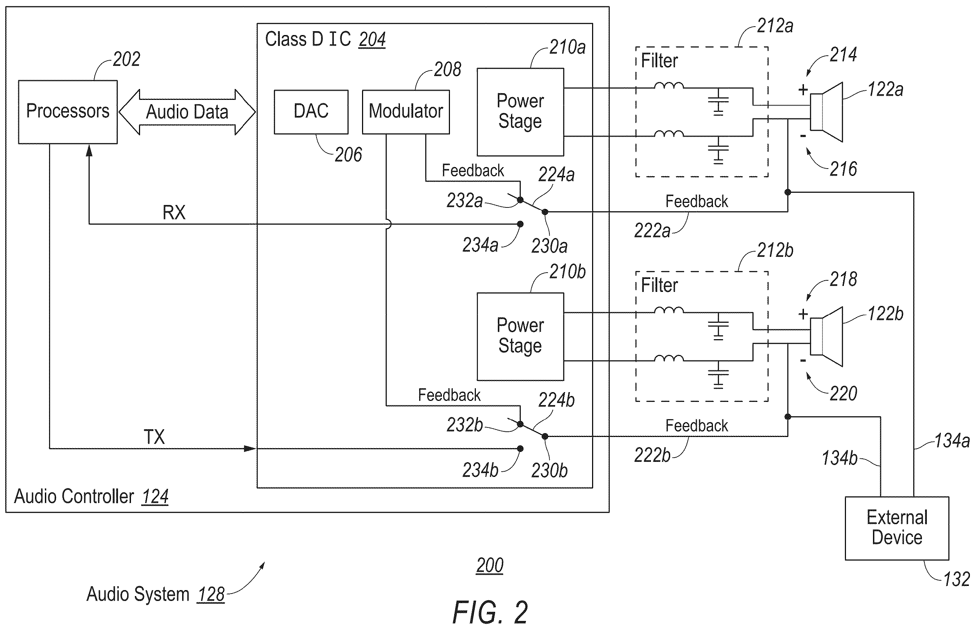

Referring to Figure 2, an example block diagram 200 of the audio system of one embodiment of the present disclosure is illustrated. In the present example, the audio system 128 includes one audio controller 124 connected to two loudspeakers 122. For simplicity, other loudspeakers 122 and/or microphones 126 are omitted. The audio controller 124 may include one or more processors 202 configured to perform various operations. For instance, the processors 202 may include one or more digital signal processors (DPSs) configured to process digital signals associated with audio output (e.g., decoding digital audio files). Additionally or alternatively, the processors 202 may include one or more microcontroller units (MCUs) configured to control the operations of the audio controller such as memory, input/output or the like.

The audio controller 124 may further include a Class D integrated circuit (IC) 204 in communication with the processors 202 and configured to convert the electrical power into audio signals. More specifically, the Class D IC 204 may include a digital-to-analog converter (DAC) 206 configured to convert the digital signal received from the processors 202 into analog signals to facilitate the audio output via the loudspeakers 122. The Class D IC 204 may further include a modulator 208 configured to modulate the power stage for playing audio out. For instance, the modulator 208 may be configured to convert the audio input into pulse signals. The modulator 208 may use pulse-width modulation (PWM) to encode the amplitude values of the original audio signal in the pulse widths of a square wave output. The Class D IC 204 may further include one or more power stages 210 each configured to drive and providing electrical power to a loudspeaker 122. In the present example illustrated with reference to Figure 2, the Class D IC 204 includes two power stages 210. A first power stage 210a may be configured to drive a first loudspeaker 122a via a first filter 212a, and a second power stage 210b may be configured to drive a second loudspeaker 122b via a second filter 212b. The filters 212 may be an inductance (L) and capacitor (C) filters (LC filters) that include various components such as inductors and capacitors to provide low-pass filtering operations to the audio signal such that high-frequency noise is filtered out (or reduced).

As illustrated in Figure 2, each power stage 210 may drive the respective loudspeaker 122 via two wires/connections through two terminals of the loudspeakers 122. More specifically, the first power stage 210a may be configured to connect to and drive the first loudspeaker 122a via a positive wire through a positive terminal 214 and a negative wire through a negative terminal 216 of the first loudspeaker 122a. The second power stage 210b may be configured to connect to and drive the second loudspeaker 122b via a positive wire through a positive terminal 218 and a negative wire through a negative terminal 220 of the second loudspeaker 122b. The terminals of loudspeakers 122 may be provided with exposed metal connectors to allow easier access. Similarly, the corresponding terminals of the audio controller side 124 may also be provided with exposed metal connectors to allow easier access. (To be discussed in detail below.)

Each loudspeaker 122 may further provide a feedback signal to the modulator 208 of the Class D IC 204 through a feedback wire 222. In the present example, the first loudspeaker 122a may provide a first feedback signal to the modulator 208 via a first feedback wire 222a connected to the negative wire or terminal 216. The second loudspeaker 122b may provide a second feedback signal to the modulator 208 via a second feedback wire 222b connected to the negative wire or terminal 220. Although both of the feedback wires 222 are connected to the negative wires or terminals in the example illustrated in Figure 2, the present disclosure is not limited thereto. In alternative examples, one or more feedback signals may be drawn from the positive wire or terminals under essentially the same concept.

In the present example, a technician may use the external device 132 to access the processors 202 by connecting the debugging cable 134 to the first feedback wires 222. As illustrated in Figure 2, the feedback wires 222 may be connected to either the modulator 208 or to the processors 202 through respective switches 224. More specifically, the Class D IC 204 may be provided with a first switch 224a having a first terminal 230a connected to the feedback wire 222a from the first loudspeaker 122a. The first switch 224a may include a second terminal 232a (e.g., upper side) in electrical connection with the modulator 208 and a third terminal 234a (e.g., lower side) in electrical connection with the processors 202. The first switch 224a may selectively connect the first terminal 230a with one of the second terminal 232a and the third terminal 234a. In a normal operating mode when the first terminal 230a is connected to the second terminal 232a, the modulator 208 is connected to the negative wire of the first loudspeaker 122a to receive the feedback signal thereof. In a debugging mode when the first terminal 230a is connected to the third terminal 234a, the first feedback wire 222a is connected to the processor 202 to allow a direct connection between the external device 132 and the processors 202. In the present example, the first feedback 222a may operate as a receiving line RX configured to carry signals received by the processors 202 from the external device 132. The switching of the first switch may be controlled via the processor through the in-vehicle network 112.

Similarly, the Class D IC 204 may be provided with a second switch 224b having a first terminal 230b connected to the second feedback wire 222b from the second loudspeaker 122b. The second switch 224b may include a second terminal 232b (e.g., upper side) in electrical connection with the modulator 208 and a third terminal 234b (e.g., lower side) in electrical connection with the processors 202. The second switch 224b may selectively connect the first terminal 230b with one of the second terminal 232b and the third terminal 234b. In the normal operating mode when the first terminal 230b is connected to the second terminal 232b, the modulator 208 is connected to the negative wire of the second loudspeaker 122b to receive the feedback signal thereof. In a debugging mode when the first terminal 230b is connected to the third terminal 234b, the second feedback wire 222b is connected to the processor 202 to allow a direct connection between the external device 132 and the processors 202. In the present example, the second feedback 222a may operate as a transmitting line TX configured to carry signals transmitted from the processors 202 to the external device 132. The switching of the second switch may be controlled via the processor 106 through the in-vehicle network 112.

In the debugging mode in which the first terminal 230 is connected to the third terminal 234 for both the switches 224a, 224b, the audio controller 124 may not perform the audio output and/or input operations. Instead, the audio controller 124 is configured to perform the debugging operations by communicating with the external device 132. Once the debugging operations are done, the switches 224 may receive a command from the in-vehicle network 112 to switch back from the third terminal 234 to the second terminal 232 such that the audio controller 124 enters the normal operating mode and resumes the audio output and/or input.

Although the feedback wires 222 are directed connected to one of the terminals of the loudspeakers 122 in the present example, the present disclosure is not limited thereto. In an alternative example, the feedback wires may be connected directed to the corresponding power stages 210 without going through the filters 212. In this case, the feedback signal may be in the digital form (e.g., PWM signals). The external device 132 may be connected to the digital feedback wires under essentially the same principle.

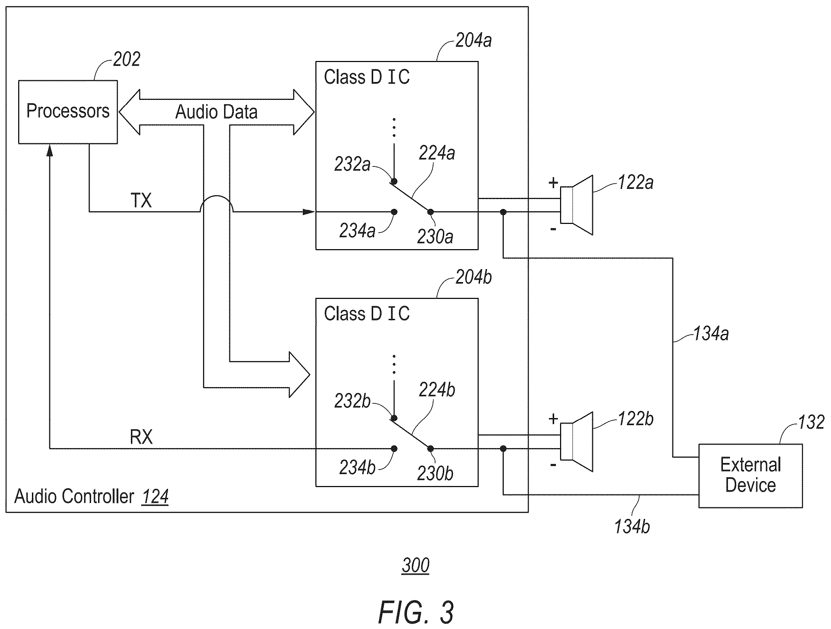

Although the both the transmitting line TX and the receiving line RX for debugging pass through a single Class D IC 204 in the example illustrated with reference to Figure 2, the present disclosure is not limited thereto. Referring to Figure 3, an example block diagram 300 of the audio system of another embodiment of the present disclosure is illustrated. With continuing reference to Figures 1 and 2, the debugging data communicated between the external device 132 and the processors 202 passes through a plurality of Class D ICs 204 in the present example. More specifically, the transmitting line TX passes through a first Class D IC 204a via a first switch 224a. The first Class D IC 204a is configured to drive a first loudspeaker 122a. A receiving line RX passes through a second Class D IC 204b via a second switch 224b. The second Class D IC 204b is configured to drive a second loudspeaker 122b.

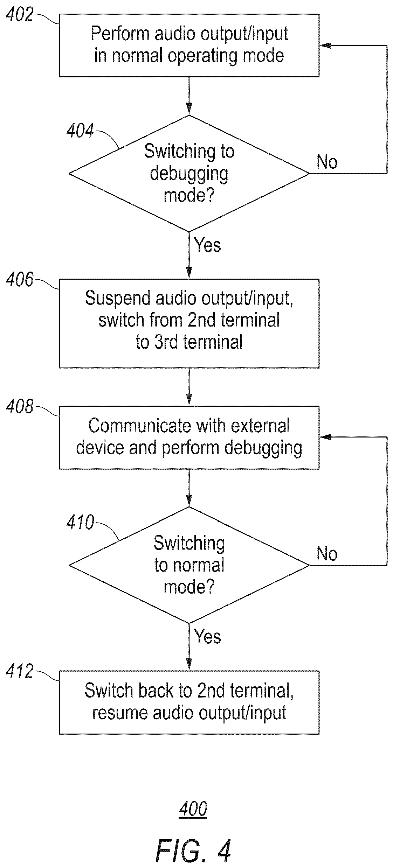

Referring to Figure 4, an example flow diagram of a process 400 for switching the audio controller between the normal operating mode and the debugging mode of one embodiment of the present disclosure is illustrated. With continuing reference to Figure 1 to 3, the process 400 may be implemented via the audio controller 124.

At operation 402, the audio controller 124 operates in the normal operating mode without enabling the debugging operations. For instance, the audio controller 124 may communicate with one or more loudspeakers 122 and/or microphones 126 to perform audio output and/or input functions.

At operation 404, the audio controller 124 verifies if a switching signal indicative of a user intent to switch from the current normal operating mode to the debugging mode has been detected. There are a couple of ways the switching signals may be generated and received. In one example, a user/technician may make a manual input to the vehicle system 104 (e.g., via the HMI controls 114 and/or via touchscreen display 166) to activate the debugging mode to the audio controller 124. The switching signal may be sent to the audio controller 124 via the in-vehicle network 112.

Alternatively, the audio controller 124 may be configured to automatically detect the activation of the debugging mode without requiring a manual input by the technician. In the lack of a dedicated debugging port, the debugging operation of the present disclosure requires the technician to physically connect the external device 132 to the designated feedback wires 222. Since the connected, the external device 132 may cause signal variations on the designated feedback wire 222 (e.g., voltage variation). The signal variations may be recognized by the audio controller 124 as an indication that a technician is performing debugging to the audio controller 124. To increase the automatic detection accuracy, the audio controller 124 may be configured to recognize the debugging mode when both the designated feedback wires 222 exhibits the predetermine signal variation. In other words, if the signal variation is only detected on one designated feedback wire 222, the audio controller 124 may refrain from recognizing the signal variation as the debugging mode indication. To further increase the detection accuracy, a timer may be utilized to prevent misidentifications. For instance, the audio controller 124 may recognize the switching indication only after both designated feedback wires 222 have exhibited the signal variation for at least 5 seconds.

As discussed above, the debugging cable 134 may be connected to the feedback wires in various manners. For instance, the loudspeaker terminals designated for debugging may be provided with exposed metal contactors to allow easier connections. Additionally or alternatively, the terminals on the audio controller side corresponding to the designated feedback wires 222 may also be provided with exposed metal contactor to allow easier connections. Additionally or alternatively, the designated feedback wires 222 may be specially designed with exposed metal contacting portions to facilitate the easier connections. For instance, the designated feedback wires 222 may be provided with removable insulation covers. Once the insulation covers are remove, the metal contacting portions may be exposed. The debugging cable 134 may include one or more of signal probes, and/or clamps configured to connect to the feedback wires 222 in a non-intrusive manner. In an alternative example, when the above options are not available, the technician may connect to the feedback wires 222 in an intrusive manner, e.g., punching through the insulation lay of the wires via sharp probes.

If the answer for operation 404 is no, this condition may be indicative that no switching signal (e.g., manual or automatic) has been detected, the process 400 returns to operation 402. In this case, the audio controller 124 continuous to operate in the normal operating mode. Otherwise, if the answer for operation 404 is yes, this condition may be indicative of the switching signal not being detected, the process 400 proceeds to operation 406.

At operation 406, responsive to detecting the switching signal, the audio controller 124 suspends the audio output and/or input, and operates the switches 224 to switch from the second terminal to the third terminal to provide direct data connections between the external device 132 and the processors 202.

At operation 408, the audio controller 124 performs the debugging operations by allowed the external device 132 to access the processors 202. The technician may use the external device 132 to perform testing and programming to the processors 202.

At operation 410, the audio controller 124 verifies if a second switching signal has been detected. The second switching signal may be indicative of a user intent to switch from the current debugging mode back to the normal operating mode. Similar to operation 404, the second switching signal may be manually input by the technician via the HMI controls 114 and received via the in-vehicle network 112. Alternatively, the audio controller 124 may detect the debugging cable 134 has been removed from one or both of the designated feedback wires 222 indicating the technician has completed the debugging operations. Similarly, a timer (e.g., 5 seconds) may be used to prevent misidentification of the second switching signal.

If the answer for operation 410 is no, this condition may be indicative of no second switching signal (e.g., manual or automatic) being detected, the process 400 returns to operation 408 and the audio controller 124 continuous to operate in the debugging mode. Otherwise, if the answer for operation 404 is yes, this condition may be indicative of the second switching signal being detected, the process 400 proceeds to operation 412.

At operation 412, the audio controller 124 operates the switches 224 to switch from the third terminal to the second terminal to disable direct data connections between the external device 132 and the processors 202. The audio controller 124 resumes the audio output and/or input via the loudspeakers 122 and/or microphones 126.

Although the above circuit structure and process is described with reference to the audio controller 124, the present disclosure is not limited thereto. The present disclosure may be applied to other components of the vehicle system 104 under essentially the same concept to allow debugging of those components without providing a dedicated debugging port. For instance, the present disclosure may be applied to the video controller 118 for debugging and programming purposes. The present disclosure provide access to the video controller 118 via one or more existing wires/cable connecting the video controller 118 with the display 116 and/or the camera 120 under essentially the same concept.

The algorithms, methods, or processes disclosed herein can be deliverable to or implemented by a computer, controller, or processing device, which can include any dedicated electronic control unit or programmable electronic control unit. Similarly, the algorithms, methods, or processes can be stored as data and instructions executable by a computer or controller in many forms including, but not limited to, information permanently stored on non-writable storage media such as read only memory devices and information alterably stored on writeable storage media such as compact discs, random access memory devices, or other magnetic and optical media. The algorithms, methods, or processes can also be implemented in software executable objects. Alternatively, the algorithms, methods, or processes can be embodied in whole or in part using suitable hardware components, such as application specific integrated circuits, field-programmable gate arrays, state machines, or other hardware components or devices, or a combination of firmware, hardware, and software components.

While exemplary embodiments are described above, it is not intended that these embodiments describe all possible forms encompassed by the claims. The words used in the specification are words of description rather than limitation, and it is understood that various changes may be made without departing from the spirit and scope of the disclosure. The words processor and processors may be interchanged herein, as may the words controller and controllers.

As previously described, the features of various embodiments may be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics may be compromised to achieve desired overall system attributes, which depend on the specific application and implementation. These attributes may include, but are not limited to strength, durability, marketability, appearance, packaging, size, serviceability, weight, manufacturability, ease of assembly, etc. As such, embodiments described as less desirable than other embodiments or prior art implementations with respect to one or more characteristics are not outside the scope of the disclosure and may be desirable for particular applications.

### ADDITIONAL EXAMPLES

The following examples pertain to further claimed or unclaimed features. Any of the described examples which do not fully correspond to the invention as defined in the claims is thus not according to the invention and present for illustration purposes only or to highlight specific aspects or features of the claims.

Example 1: An audio system in a vehicle comprising: at least one controller including one or more processors being programmed to provide an output audio signal; a first integrated circuit (IC) configured to drive a first loudspeaker; and a first switch including: a first terminal being operably coupled to a first feedback wire from the first loudspeaker, a second terminal being operably coupled to a component of the first IC, and a third terminal being operably coupled with the one or more processors, wherein the first switch is configured to selectively connect the first terminal to one of the second terminal or the third terminal.

Example 2: The audio system of example 1, wherein the controller is programmed to: responsive to the first terminal being connected to the second terminal, provide output audio signal to the first loudspeaker; and responsive to detecting a first switching signal that is indicative of a user intent to access the one or more processors for debugging, operate the first switch to connect the first terminal with the third terminal such that the first feedback wire is connected to the one or more processors.

Example 3: The audio system of example 2, wherein the first switching signal is generated via a manual input to the vehicle by the user.

Example 4: The audio system of example 2 or 3, wherein the first switching signal is automatically detected by a signal variance on the first feedback wire, and wherein the first switching signal is indicative of the first feedback wire being connected to an external device.

Example 5: The audio system of example 4, wherein the first switching signal is detected after the signal variance has been detected for a length of time that exceeds a predefined time threshold.

Example 6: The audio system of any of examples 2 to 5, wherein the controller is further programmed to: responsive to detecting a second switching signal, operate the first switch to connect the first terminal with the second terminal, the second switching signal being indicative of the debugging being complete.

Example 7: The audio system of any of examples 1 to 6, wherein the first IC is further configured to drive a second loudspeaker; and the controller further comprises: a second switch including a first terminal being operably coupled to a second feedback wire from the second loudspeaker, a second terminal being operably coupled to a component of the first integrated circuit, and a third terminal being operably coupled to the one or more processors, wherein the first switch is configured to selectively connect the first terminal with one of the second terminal or the third terminal.

Example 8: The audio system of any of examples 1 to 7, wherein the controller further comprising: a second integrated circuit (IC) configured to drive a second loudspeaker; and a second switch including: a first terminal in electrical connection with a second feedback wire from the second loudspeaker, a second terminal in electrical connection with a component of the second integrated circuit, and a third terminal in electrical connection with the one or more processors, wherein the first switch is configured to selectively connect the first terminal with one of the second terminal or the third terminal.

Example 9: An audio system comprising: at least one controller including one or more processors being programmed to provide an output audio signal; a first integrated circuit (IC) configured to drive a first loudspeaker; and a first switch including: a first terminal being operably coupled to the first loudspeaker, a second terminal being operably coupled to the first IC, and a third terminal being operably coupled with the one or more processors, wherein the first switch is configured to selectively connect the first terminal to one of the second terminal or the third terminal.

Example 10: The audio system of example 9, wherein the first terminal is coupled to a first feedback wire from the first loudspeaker.

Example 11: The audio system of example 10, wherein the second terminal is operably coupled to a modulator of the first IC.

Example 12: The audio system of example 10 or 11, wherein the controller is programmed to: responsive to the first terminal being connected to the second terminal, provide output audio signal to the first loudspeaker; and responsive to detecting a first switching signal that is indicative of a user intent to access the one or more processors for debugging, operate the first switch to connect the first terminal with the third terminal such that the first feedback wire is connected to the one or more processors.

Example 13: The audio system of example 12, wherein the first switching signal is generated via a manual input to audio system by the user.

Example 14: The audio system of example 12 or 13, wherein the first switching signal is automatically detected by a signal variance on the first feedback wire, and wherein the first switching signal is indicative of the first feedback wire being connected to an external device.

Example 15: The audio system of example 14, wherein the first switching signal is detected after the signal variance has been detected for a length of time that exceeds a predefined time threshold.

Example 16: The audio system of any of examples 12 to 15, wherein the controller is further programmed to: responsive to detecting a second switching signal, operate the first switch to connect the first terminal with the second terminal, the second switching signal being indicative of the debugging being complete.

Example 17: The audio system of any of examples 10 to 16, wherein the first IC is further configured to drive a second loudspeaker; and the controller further comprises: a second switch including a first terminal being operably coupled to a second feedback wire from the second loudspeaker, a second terminal being operably coupled to a modulator of the first integrated circuit, and a third terminal being operably coupled to the one or more processors, wherein the first switch is configured to selectively connect the first terminal with one of the second terminal or the third terminal.

Example 18: The audio system of any of examples 10 to 17, wherein the controller further comprising: a second integrated circuit (IC) configured to drive a second loudspeaker; and a second switch including: a first terminal in electrical connection with a second feedback wire from the second loudspeaker, a second terminal in electrical connection with a component of the second integrated circuit, and a third terminal in electrical connection with the one or more processors, wherein the first switch is configured to selectively connect the first terminal with one of the second terminal or the third terminal.

Example 19: An audio system for an automobile, the audio system comprising: one or more processors being programmed to provide an output audio signal; a first integrated circuit (IC) configured to drive a first loudspeaker; and a first switch including: a first terminal being operably coupled to a first feedback wire from the first loudspeaker, a second terminal being operably coupled to a component of the first IC, and a third terminal being operably coupled with the one or more processors, wherein the first switch is configured to selectively connect the first terminal to one of the second terminal or the third terminal.

Example 20: The audio system of example 19, further comprising: a second switch including: a first terminal being operably coupled to a second feedback wire from a second loudspeaker, a second terminal being operably coupled to a modulator of the first integrated circuit, and a third terminal being operably coupled to the one or more processors, wherein the first switch is configured to selectively connect the first terminal with one of the second terminal or the third terminal.

## Claims

1. An audio system in a vehicle comprising:
at least one controller including one or more processors being programmed to provide an output audio signal;
a first integrated circuit (IC) configured to drive a first loudspeaker; and
a first switch including:
a first terminal being operably coupled to a first feedback wire from the first loudspeaker,
a second terminal being operably coupled to a component of the first IC, and
a third terminal being operably coupled with the one or more processors, wherein the first switch is configured to selectively connect the first terminal to one of the second terminal or the third terminal.

2. The audio system of claim 1, wherein the controller is programmed to:
responsive to the first terminal being connected to the second terminal, provide output audio signal to the first loudspeaker; and
responsive to detecting a first switching signal that is indicative of a user intent to access the one or more processors for debugging, operate the first switch to connect the first terminal with the third terminal such that the first feedback wire is connected to the one or more processors.

3. The audio system of claim 2, wherein the first switching signal is generated via a manual input to the vehicle by the user.

4. The audio system of claim 2 or 3, wherein the first switching signal is automatically detected by a signal variance on the first feedback wire, and wherein the first switching signal is indicative of the first feedback wire being connected to an external device.

5. The audio system of claim 4, wherein the first switching signal is detected after the signal variance has been detected for a length of time that exceeds a predefined time threshold.

6. The audio system of any of claims 2 to 5, wherein the controller is further programmed to:
responsive to detecting a second switching signal, operate the first switch to connect the first terminal with the second terminal, the second switching signal being indicative of the debugging being complete.

7. The audio system of any preceding claim, wherein the first IC is further configured to drive a second loudspeaker; and
the controller further comprises:
a second switch including
a first terminal being operably coupled to a second feedback wire from the second loudspeaker,
a second terminal being operably coupled to a component of the first integrated circuit, and
a third terminal being operably coupled to the one or more processors, wherein the first switch is configured to selectively connect the first terminal with one of the second terminal or the third terminal.

8. The audio system of any preceding claim, wherein the controller further comprising:
a second integrated circuit (IC) configured to drive a second loudspeaker; and
a second switch including:
a first terminal in electrical connection with a second feedback wire from the second loudspeaker,
a second terminal in electrical connection with a component of the second integrated circuit, and
a third terminal in electrical connection with the one or more processors, wherein the first switch is configured to selectively connect the first terminal with one of the second terminal or the third terminal.

9. A vehicle comprising:
at least one controller including one or more processors being programmed to provide an output audio signal;
a first integrated circuit (IC) configured to drive a first loudspeaker; and
a first switch including:
a first terminal being operably coupled to the first loudspeaker,
a second terminal being operably coupled to the first IC, and
a third terminal being operably coupled with the one or more processors, wherein the first switch is configured to selectively connect the first terminal to one of the second terminal or the third terminal.

10. The vehicle of claim 9, wherein the first terminal is coupled to a first feedback wire from the first loudspeaker.

11. The vehicle of claim 10, wherein the second terminal is operably coupled to a modulator of the first IC.

12. The vehicle of claim 10 or 11, wherein the controller is programmed to:
responsive to the first terminal being connected to the second terminal, provide output audio signal to the first loudspeaker; and
responsive to detecting a first switching signal that is indicative of a user intent to access the one or more processors for debugging, operate the first switch to connect the first terminal with the third terminal such that the first feedback wire is connected to the one or more processors.

13. The vehicle of claim 12, wherein the first switching signal is generated via a manual input to audio system by the user.

14. The vehicle of claim 12 or 13, wherein the first switching signal is automatically detected by a signal variance on the first feedback wire, and wherein the first switching signal is indicative of the first feedback wire being connected to an external device.

15. The vehicle of claim 14, wherein the first switching signal is detected after the signal variance has been detected for a length of time that exceeds a predefined time threshold.
